# EUROPEAN PATENT APPLICATION

(11) **EP 4 336 729 A1**
(43) Date of publication of application: **13.03.2024**
(21) Application number: 23193005.8
(22) Date of filing: 23.08.2023
(51) Int. Cl.: H03H 9/02, H03H 9/17, H03H 9/13

(54) **BAW RESONATOR WITH BRAGG MIRROR DIMENSIONED TO SUPPRESS FRAME MODES**

(30) Priority: 30.08.2022 US 202263402291 P; 18.07.2023 US 202318354272
(71) Applicant: Qorvo US, Inc., Greensboro, NC 27409 (US)
(72) Inventor: TAJIC, Alireza, Apopka, 32703 (US); MODARRES-ZADEH, Mohammad J., Apopka, 32703 (US); BERER, Thomas, Apopka, 32703 (US)
(74) Representative: D Young & Co LLP

(57) **Abstract**

The present disclosure relates to a bulk acoustic wave, BAW, resonator (36) that includes a bottom electrode (48), a top electrode structure (44) with a border ring, BO, structure (56), a piezoelectric layer (42) sandwiched between the bottom electrode (48) and the top electrode (58), and a reflector (38) with a high acoustic impedance layer (80-1,80-2) embedded in a low acoustic impedance region (78). Herein, the BO structure (56) is formed about a periphery of the top electrode structure (44) and defines a BO region (66) of the BAW resonator (36). The first high acoustic impedance layer (80-1) is vertically underneath the bottom electrode (48) and is separated from the bottom electrode (48) by a first portion of the low acoustic impedance region (78-1). A width (W_{FH}) of the first high acoustic impedance layer (80-1) is smaller than a width (W_{TE}) of the top electrode structure (44), such that the first high acoustic impedance layer (80-1) does not extend completely through the BO region (66) of the BAW resonator (36).

## Description

### Related Applications

This application claims the benefit of provisional patent application serial number 63/402,291, filed August 30, 2022, the disclosure of which is hereby incorporated herein by reference in its entirety.

### Field

The present disclosure relates to a bulk acoustic wave (BAW) resonator, and particularly but not exclusively to a BAW resonator with a border ring (BO) structure and a leaky reflector.

### Background

Acoustic resonators and, particularly, bulk acoustic wave (BAW) resonators are used in many high-frequency communication applications. In particular, BAW resonators are often employed in filter networks that operate at frequencies above 1.5 gigahertz (GHz) and require a flat passband, have exceptionally steep filter skirts and squared shoulders at the upper and lower ends of the passband, and provide excellent rejection outside of the passband. BAW-based filters also have a relatively low insertion loss, tend to decrease in size as the frequency of operation increases, and are relatively stable over wide temperature ranges. As such, BAW-based filters are the filter of choice for many 3rd Generation (3G) and 4th Generation (4G) wireless devices, and are destined to dominate filter applications for 5th Generation (5G) wireless devices. Most of these wireless devices support cellular, wireless fidelity (Wi-Fi), Bluetooth, and/or near field communications on the same wireless device, and as such, pose extremely challenging filtering demands.

### Summary

Particular aspects are set out in the appended independent claims. Various optional embodiments are set out in the dependent claims.

Some implementations according to the present disclosure may address balancing increasing complexity of wireless devices with improving the performance of BAW resonators and BAW-based filters as well as decreasing the cost and size associated therewith.

The present disclosure relates to a bulk acoustic wave (BAW) resonator with a border ring (BO) structure and a leaky reflector. The disclosed BAW resonator includes a bottom electrode, a piezoelectric layer over the bottom electrode, a top electrode structure with the BO structure over the piezoelectric layer, and the leaky reflector with a first high acoustic impedance layer and a second high acoustic impedance layer embedded in a low acoustic impedance region. Herein, the BO structure is formed about a periphery of the top electrode structure and defines a BO region of the BAW resonator. The BO region corresponds to a section of the BAW resonator that includes, resides over, and resides below the BO structure. The first high acoustic impedance layer is vertically underneath the bottom electrode and is separate from the bottom electrode by a first portion of the low acoustic impedance region. The second high acoustic impedance layer is vertically underneath the first high acoustic impedance layer and is separate from the first high acoustic impedance layer by a second portion of the low acoustic impedance region. A width of the first high acoustic impedance layer is smaller than a width of the top electrode structure, such that the first high acoustic impedance layer does not extend completely through the BO region of the BAW resonator.

In one embodiment of the BAW resonator, the BO structure has a single-step configuration.

In one embodiment of the BAW resonator, the BO structure includes a dielectric BO ring formed about an outer periphery of the BO region and a ring transition section formed about an inner periphery of the BO region.

In one embodiment of the BAW resonator, the top electrode structure further includes a top electrode, which is formed over a central portion of the piezoelectric layer and extends over the BO structure. An outer peripheral edge of the BO structure is aligned with a peripheral edge of the top electrode.

In one embodiment of the BAW resonator, the top electrode includes a first top electrode layer, which is formed over the central region of the piezoelectric layer and extends over the BO structure, an electrode seed layer formed over the first top electrode layer, and a second top electrode layer formed over the electrode seed layer.

In one embodiment of the BAW resonator, the first top electrode layer is formed of tungsten (W), molybdenum (Mo), or platinum (Pt), the electrode seed layer is formed of Titanium Tungsten (TiW) or Titanium (Ti), and the second top electrode layer is formed of aluminum copper.

In one embodiment of the BAW resonator, the BO structure has a dual-step configuration with an inner step and an outer step. The inner step and the outer step collectively form a stepped profile of raised heights that decrease from the outer periphery of the BO structure toward the central region of the piezoelectric layer.

In one embodiment of the BAW resonator, the inner step is formed due to a thickness increment of the first top electrode layer within the BO region, and the outer step is formed due to the thickness increment of the first top electrode layer within the BO region and a dielectric BO ring about an outer periphery of the BO region.

In one embodiment of the BAW resonator, the first high acoustic impedance layer does not extend into the BO region of the BAW resonator, and a width difference between a peripheral edge of the first high acoustic impedance layer and an outer peripheral edge of the BO structure is the same as a width of the BO region of the BAW resonator.

In one embodiment of the BAW resonator, a width of the second high acoustic impedance layer is smaller than the width of the top electrode structure, such that the second high acoustic impedance layer does not extend completely through the BO region of the BAW resonator.

In one embodiment of the BAW resonator, the first high acoustic impedance layer does not extend into the BO region of the BAW resonator, and the width difference between a peripheral edge of the first high acoustic impedance layer and an outer peripheral edge of the BO structure is the same as a width of the BO region of the BAW resonator. The second high acoustic impedance layer does not extend into the BO region of the BAW resonator, and a peripheral edge of the second high acoustic impedance layer is aligned with the peripheral edge of the first high acoustic impedance layer.

In one embodiment of the BAW resonator, the width of the second high acoustic impedance layer is greater than the width of the first high acoustic impedance layer, and the first high acoustic impedance layer is confined within a peripheral edge of the second high acoustic impedance layer.

In one embodiment of the BAW resonator, the width of the second high acoustic impedance layer is not smaller than the width of the top electrode structure.

In one embodiment of the BAW resonator, the width of the second high acoustic impedance layer is greater than the width of the top electrode structure, such that the second high acoustic impedance layer extends completely through the BO region of the BAW resonator.

In one embodiment of the BAW resonator, the first high acoustic impedance layer and the second high acoustic impedance layer are formed of W, Mo, or Pt, while the low acoustic impedance region is formed of silicon oxide.

According to one embodiment, the BAW resonator further includes a passivation layer that covers the top electrode structure and portions of the piezoelectric layer exposed through the top electrode structure. The passivation layer is formed of Silicon Nitride (SiN), SiO2, or Silicon Oxynitride (SiON), with a thickness between 250 Å and 5000 Å.

In another aspect, any of the foregoing aspects individually or together, and/or various separate aspects and features as described herein, may be combined for additional advantage. Any of the various features and elements as disclosed herein may be combined with one or more other disclosed features and elements unless indicated to the contrary herein.

Those skilled in the art will appreciate the scope of the present disclosure and realize additional aspects thereof after reading the following detailed description of the illustrative embodiments in association with the accompanying drawing figures.

### Brief Description of the Drawing Figures

The accompanying drawing figures incorporated in and forming a part of this specification illustrate several aspects of the disclosure, and together with the description serve to explain the principles of the disclosure.
FIG. 1 is a diagram illustrating a conventional bulk acoustic wave (BAW) resonator.
FIG. 2 is a diagram graphically illustrating the magnitude and phase of the electrical impedance as a function of the frequency for a relatively ideal BAW resonator.
FIGs. 3A-3C are diagrams graphically illustrating phase curves for various conventional BAW resonators.
FIG. 4 is a diagram illustrating a conventional BAW resonator with a top electrode including a border ring (BO).
FIG. 5 is a diagram graphically illustrating the relationship of a BO ring width to its quality factor at an antiresonance frequency (Qₚ) and the relative strength of BO modes formed.
FIG. 6 is a diagram graphically illustrating phase curves for BAW resonators with and without BO rings.
FIGs. 7A-7B are cross-sectional diagrams illustrating an example BAW resonator with a BO structure and a leaky reflector according to embodiments of the present disclosure.
FIGs. 8A-8B are cross-sectional diagrams illustrating an example BAW resonator with a dual-step BO structure and a leaky reflector according to embodiments of the present disclosure.
FIGs. 9A -9C are diagrams graphically illustrating simulated 1-|S₁₁| responses for various configurations of BAW resonators.
FIGs. 10A -10C are diagrams graphically illustrating quality factor simulation results for various configurations of BAW resonators.

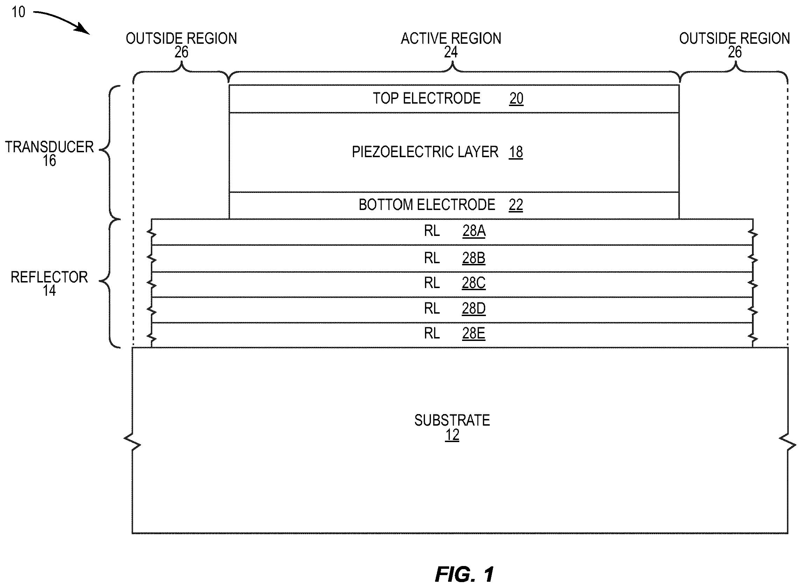

It will be understood that for clear illustrations, FIGs. 1-10C may not be drawn to scale.

### Detailed Description

The embodiments set forth below represent the necessary information to enable those skilled in the art to practice the embodiments and illustrate the best mode of practicing the embodiments. Upon reading the following description in light of the accompanying drawing figures, those skilled in the art will understand the concepts of the disclosure and will recognize applications of these concepts not particularly addressed herein. It should be understood that these concepts and applications fall within the scope of the disclosure and the accompanying claims.

It will be understood that, although the terms first, second, etc. may be used herein to describe various elements, these elements should not be limited by these terms. These terms are only used to distinguish one element from another. For example, a first element could be termed a second element, and, similarly, a second element could be termed a first element, without departing from the scope of the present disclosure. As used herein, the term "and/or" includes any and all combinations of one or more of the associated listed items.

It will be understood that when an element such as a layer, region, or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present. Likewise, it will be understood that when an element such as a layer, region, or substrate is referred to as being "over" or extending "over" another element, it can be directly over or extend directly over the other element or intervening elements may also be present. In contrast, when an element is referred to as being "directly over" or extending "directly over" another element, there are no intervening elements present. It will also be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

Relative terms such as "below" or "above" or "upper" or "lower" or "horizontal" or "vertical" may be used herein to describe a relationship of one element, layer, or region to another element, layer, or region as illustrated in the Figures. It will be understood that these terms and those discussed above are intended to encompass different orientations of the device in addition to the orientation depicted in the Figures.

The terminology used herein is for the purpose of describing particular embodiments only and is not intended to be limiting of the disclosure. As used herein, the singular forms "a," "an," and "the" are intended to include the plural forms as well, unless the context clearly indicates otherwise. It will be further understood that the terms "comprises," "comprising," "includes," and/or "including" when used herein specify the presence of stated features, integers, steps, operations, elements, and/or components, but do not preclude the presence or addition of one or more other features, integers, steps, operations, elements, components, and/or groups thereof.

Unless otherwise defined, all terms (including technical and scientific terms) used herein have the same meaning as commonly understood by one of ordinary skill in the art to which this disclosure belongs. It will be further understood that terms used herein should be interpreted as having a meaning that is consistent with their meaning in the context of this specification and the relevant art and will not be interpreted in an idealized or overly formal sense unless expressly so defined herein.

Embodiments are described herein with reference to schematic illustrations of embodiments of the disclosure. As such, the actual dimensions of the layers and elements can be different, and variations from the shapes of the illustrations as a result, for example, of manufacturing techniques and/or tolerances, are expected. For example, a region illustrated or described as square or rectangular can have rounded or curved features, and regions shown as straight lines may have some irregularity. Thus, the regions illustrated in the figures are schematic and their shapes are not intended to illustrate the precise shape of a region of a device and are not intended to limit the scope of the disclosure. Additionally, sizes of structures or regions may be exaggerated relative to other structures or regions for illustrative purposes and, thus, are provided to illustrate the general structures of the present subject matter and may or may not be drawn to scale. Common elements between figures may be shown herein with common element numbers and may not be subsequently re-described.

The present disclosure relates to a bulk acoustic wave (BAW) resonator, and particularly to a BAW resonator with a border ring (BO) structure and a leaky reflector. The disclosed BAW resonator is balanced between its quality factor and BO mode suppression.

Prior to delving into the details of these concepts, an overview of BAW resonators and filters that employ BAW resonators is provided. BAW resonators are used in many high-frequency filter applications. An example BAW resonator 10 is illustrated in FIG. 1. The BAW resonator 10 is a solidly mounted resonator (SMR) type BAW resonator 10 and generally includes a substrate 12, a reflector 14 mounted over the substrate 12, and a transducer 16 mounted over the reflector 14. The transducer 16 rests on the reflector 14 and includes a piezoelectric layer 18, which is sandwiched between a top electrode 20 and a bottom electrode 22. The top and bottom electrodes 20, 22 may be formed of tungsten (W), molybdenum (Mo), platinum (Pt), or like material, and the piezoelectric layer 18 may be formed of aluminum nitride (AIN), zinc oxide (ZnO) or other appropriate piezoelectric material. Although shown in FIG. 1 as including a single layer, the piezoelectric layer 18, the top electrode 20, and/or the bottom electrode 22 may include multiple layers of the same material, multiple layers in which at least two layers are different materials, or multiple layers in which each layer is a different material.

The BAW resonator 10 is divided into an active region 24 and an outside region 26. The active region 24 generally corresponds to the section of the BAW resonator 10 where the top and bottom electrodes 20, 22 overlap and also includes the layers below the overlapping top and bottom electrodes 20, 22. The outside region 26 corresponds to the section of the BAW resonator 10 that surrounds the active region 24.

For the BAW resonator 10, applying electrical signals across the top electrode 20 and the bottom electrode 22 excites acoustic waves in the piezoelectric layer 18. These acoustic waves primarily propagate vertically. It may be appropriate in BAW resonator design to confine these vertically propagating acoustic waves in the transducer 16. Acoustic waves traveling upwardly are reflected back into the transducer 16 by an air-metal boundary at a top surface of the top electrode 20. Acoustic waves traveling downwardly are reflected back into the transducer 16 by the reflector 14, or by an air cavity, which is provided just below the transducer 16 in a film bulk acoustic resonator (FBAR).

The reflector 14 is typically formed by a stack of reflector layers (RL) 28A through 28E (referred to generally as reflector layers 28), which alternate in material composition to produce a significant reflection coefficient at the junction of adjacent reflector layers 28. Typically, the reflector layers 28 alternate between materials having high and low acoustic impedances, such as tungsten (W) and silicon dioxide (SiO₂). While only five reflector layers 28 are illustrated in FIG. 1, the number of reflector layers 28 and the structure of the reflector 14 will vary from one design to another.

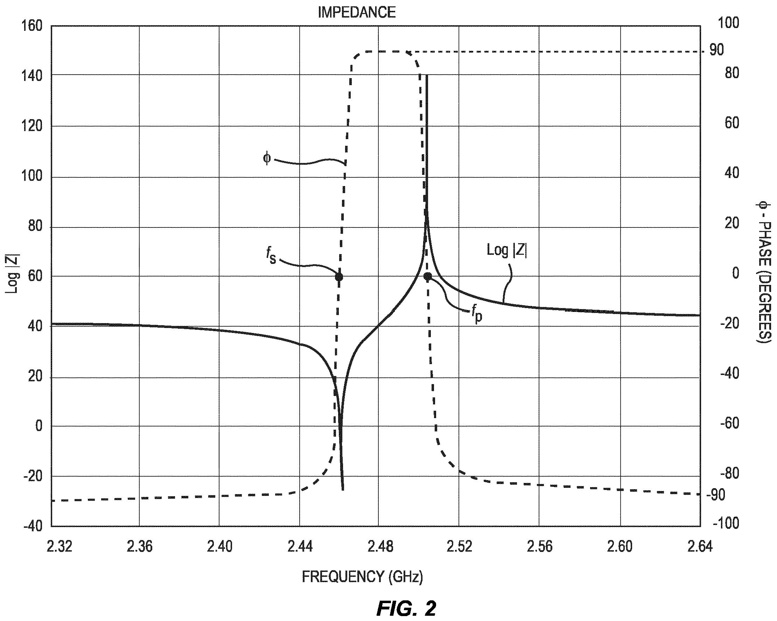

The magnitude (Z) and phase (φ) of the electrical impedance as a function of the frequency (GHz) for a relatively ideal BAW resonator 10 is provided in FIG. 2. The magnitude (Z) of the electrical impedance is illustrated by the solid line, while the phase (φ) of the electrical impedance is illustrated by the dashed line. A unique feature of the BAW resonator 10 is that it has both a resonance frequency and an antiresonance frequency. The resonance frequency is typically referred to as the series resonance frequency (*f*ₛ), and the antiresonance frequency is typically referred to as the parallel resonance frequency (*f*ₚ). The series resonance frequency (*f*ₛ) occurs when the magnitude of the impedance, or reactance, of the BAW resonator 10 approaches zero. The parallel resonance frequency (*f*ₚ) occurs when the magnitude of the impedance, or reactance, of the BAW resonator 10 peaks at a significantly high level. In general, the series resonance frequency (*f*ₛ) is a function of the thickness or height of the piezoelectric layer 18 and the mass of the top and bottom electrodes 20, 22.

For the phase, the BAW resonator 10 acts like an inductance that provides a 90° phase shift between the series resonance frequency (*f*ₛ) and the parallel resonance frequency (*f*ₚ). In contrast, the BAW resonator 10 acts like a capacitance that provides a -90° phase shift below the series resonance frequency (*f*ₛ) and above the parallel resonance frequency (*f*ₚ). The BAW resonator 10 presents a very low, near zero, resistance at the series resonance frequency (*f*ₛ), and a very high resistance at the parallel resonance frequency (*f*ₚ). The electrical nature of the BAW resonator 10 lends itself to the realization of a very high quality factor (Q) inductance over a relatively short range of frequencies, which has proven to be very beneficial in high frequency filter networks, especially those operating at frequencies around 1.8 GHz and above.

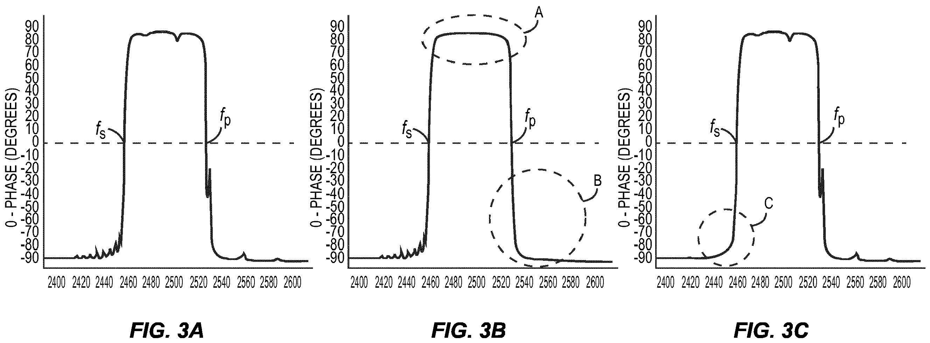

Unfortunately, the phase (φ) curve of FIG. 2 is representative of an ideal phase curve. In reality, approaching this ideal is challenging. A typical phase curve for the BAW resonator 10 of FIG. 1 is illustrated in FIG. 3A. Instead of being a smooth curve, the phase curve of FIG. 3A includes a ripple below the series resonance frequency (*f*ₛ), between the series resonance frequency (*fₛ*) and the parallel resonance frequency (*f*ₚ), and above the parallel resonance frequency (*f*ₚ). The ripple is the result of spurious modes, which are caused by spurious resonances that occur in corresponding frequencies. While the vast majority of the acoustic waves in the BAW resonator 10 propagate vertically, various boundary conditions about the transducer 16 result in the propagation of lateral (horizontal) acoustic waves, which are referred to as lateral standing waves. The presence of these lateral standing waves reduces the potential quality factor (Q) associated with the BAW resonator 10.

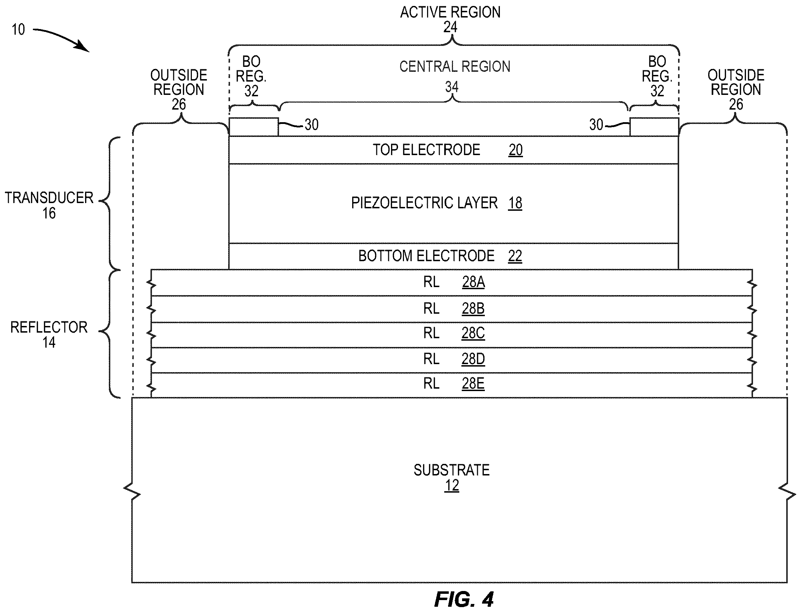

As illustrated in FIG. 4, a BO ring 30 is formed on or within (not shown) the top electrode 20 to suppress certain spurious modes. The spurious modes that are suppressed by the BO ring 30 are those above the series resonance frequency (*f*ₛ), as highlighted by circles A and B in the phase curve of FIG. 3B. Circle A shows a suppression of the ripple, and thus the spurious mode, in the passband of the phase curve, which resides between the series resonance frequency (*f*ₛ) and the parallel resonance frequency (*f*ₚ). Circle B shows suppression of the ripple, and thus the spurious modes, above the parallel resonance frequency (*f*ₚ). Notably, the spurious mode in the upper shoulder of the passband, which is just below the parallel resonance frequency (*f*ₚ), and the spurious modes above the passband are suppressed, as evidenced by the smooth or substantially ripple free phase curve between the series resonance frequency (*f*ₛ) and the parallel resonance frequency (*f*ₚ) and above the parallel resonance frequency (*f*ₚ).

The BO ring 30 corresponds to a mass loading of a portion of the top electrode 20 that extends about a periphery of the active region 24. In this regard, the BO ring 30 with mass loading forms a raised frame that is arranged about a periphery of the top electrode 20. The BO ring 30 may correspond to a thickened portion of the top electrode 20 or the application of additional layers of an appropriate material over the top electrode 20. The portion of the BAW resonator 10 that includes and resides below the BO ring 30 is referred to as a BO region 32. Accordingly, the BO region 32 corresponds to an outer perimeter portion of the active region 24 and resides inside the active region 24. In addition, a central region 34 of the BAW resonator 10 is defined laterally inside of the BO region 32 and is not covered by the BO ring 30.

While the BO ring 30 is effective at suppressing spurious modes above the series resonance frequency (*f*ₛ), the BO ring 30 has little or no impact on those spurious modes below the series resonance frequency (*f*ₛ), as shown in FIG. 3B. A technique referred to as apodization is often used to suppress the spurious modes that fall below the series resonance frequency (*f*ₛ).

Apodization works to avoid, or at least significantly reduce, any lateral symmetry in the BAW resonator 10, or at least in the transducer 16 thereof. Lateral symmetry corresponds to the footprint of the transducer 16, and avoiding the lateral symmetry corresponds to avoiding symmetry associated with the sides of the footprint. For example, one may choose a footprint that corresponds to a pentagon instead of a square or rectangle. Avoiding symmetry helps reduce the presence of lateral standing waves in the transducer 16. Circle C of FIG. 3C illustrates the effect of apodization in which the spurious modes below the series resonance frequency (*f*ₛ) are suppressed. Assuming that no BO ring 30 is provided, one can readily see in FIG. 3C that apodization fails to suppress those spurious modes above the series resonance frequency (*f*ₛ). As such, the typical BAW resonator 10 employs both apodization and the BO ring 30.

A thickness or height of the BO ring 30 may be measured in a direction perpendicular to or away from a top surface of the piezoelectric layer 18 and a width of the BO ring 30 may be measured in a direction parallel to or laterally across the piezoelectric layer 18. The thickness and the width of the BO ring 30 may be concurrently tuned to provide suppression of spurious modes and to provide improvements to the quality factor at an antiresonance frequency (Qₚ). The added mass associated with the BO ring 30 typically causes the BO region 32 to resonate at a slightly lower frequency than other portions of the active region 24. As a result, the presence of BO rings can introduce undesirable modes, or BO modes, at frequencies below the series resonance frequency (*f*ₛ).

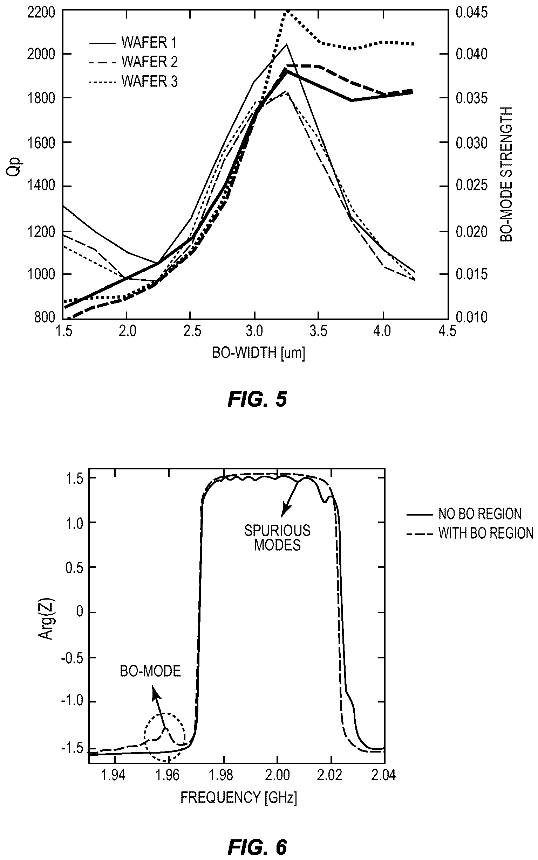

FIG. 5 is a diagram graphically illustrating the relationship of the BO ring width to the quality factor at the antiresonance frequency (Qₚ) and the relative strength of BO modes formed. In FIG. 5, the x-axis represents the BO ring width in microns (µm) while the primary y-axis represents the Qₚ and the secondary y-axis represents a relative strength or magnitude of the BO modes formed. The diagram of FIG. 5 plots data for three wafers that each includes BAW resonators with varying BO ring widths. As shown, the Qₚ values generally increase with increasing BO ring widths and a highest Qₚ value corresponds to a BO ring width of just over 3 µm. As also shown, the BO mode strength also generally increases with increasing BO ring widths. For even higher BO ring widths, the Qₚ values decrease while the BO mode strength values remain high. In this manner, a BO ring that is tuned to provide a high Qₚ may also introduce undesirable BO modes to the corresponding BAW device.

FIG. 6 is a diagram graphically illustrating the phase curves for BAW resonators with and without BO rings. As illustrated, spurious modes that are present within the passband of a BAW resonator without a BO ring are suppressed with the addition of a BO ring; however, the presence of the BO ring introduces undesirable BO modes below the passband. BO modes may be introduced outside or even inside the passband of the resonator and may restrict the design or use of BAW resonators for wide bandwidth filtering applications. If the BO modes are within the passband, insertion loss can be impacted. BO modes that are present outside of the passband can be problematic for BAW multiplexing applications where BAW filters of different frequency bands operate at the same time. In such multiplexing applications, BO modes of one BAW filter can fall into the passband of other BAW filters and introduce interference during multiplexing.

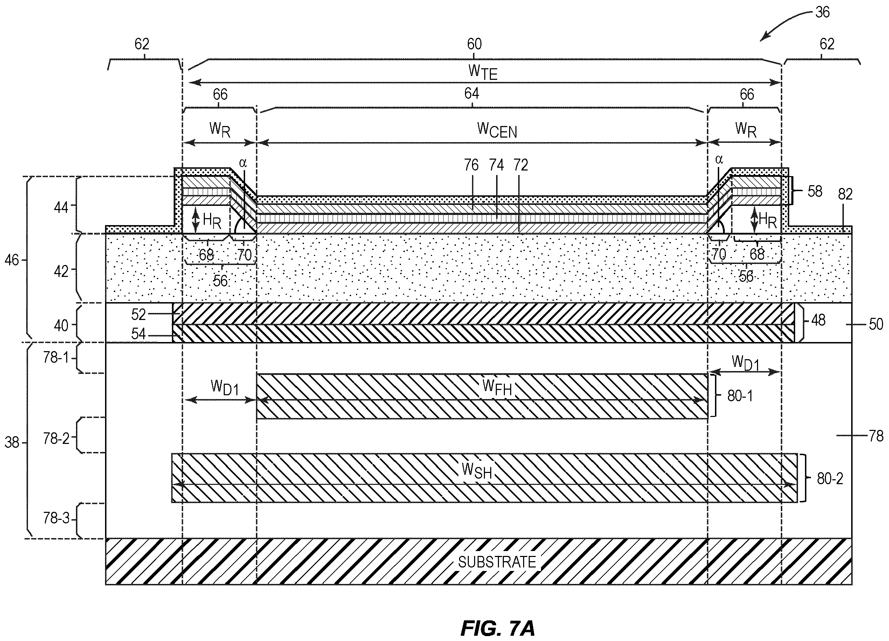

FIGs. 7A-7B are cross-sectional diagrams illustrating an example BAW resonator 36 with a reflector 38, which enables BO modes to leak into a substrate resulting in suppression of the BO modes, according to embodiments of the present disclosure. Besides the reflector 38, the BAW resonator 36 includes a bottom electrode structure 40 over the reflector 38, a piezoelectric layer 42 over the bottom electrode structure 40, and a top electrode structure 44 over the piezoelectric layer 42. The bottom electrode structure 40, the piezoelectric layer 42, and the top electrode structure 44 form a transducer 46 of the BAW resonator 36. The reflector 38 is configured to enable the BO modes to leak from the transducer 46 into a substrate, so as to suppress the BO modes of the BAW resonator 36.

In detail, the bottom electrode structure 40 includes a bottom electrode 48 and a planarization oxide 50, which surrounds the bottom electrode 48 and is capable of electrically separating the bottom electrode 48 with external bottom electrodes (not shown). The bottom electrode 48 may include two bottom electrode layers 52 and 54. The second bottom electrode layer 54 resides over the reflector 38 and may be formed of aluminum copper (AlCu), while the first bottom electrode layer 52 resides over the second bottom electrode layer 54 and may be formed of W, Mo, or Pt. The planarization oxide 50 may be formed of SiO₂.

The piezoelectric layer 42 is formed over the bottom electrode structure 40 and at least fully covers the bottom electrode 48. The piezoelectric layer 42 may be formed of AlN, ZnO or other appropriate piezoelectric materials, and may have a thickness between 0.3 µm and 1.4 µm.

The top electrode structure 44, which includes a BO structure 56 and a top electrode 58, is formed over the piezoelectric layer 42 and is vertically above the bottom electrode 48. The BO structure 56 is formed over the piezoelectric layer 42 and about a periphery of the top electrode structure 44, such that a central portion of the piezoelectric layer 42 is not covered by the BO structure 56. The top electrode 58 is formed over the central portion of the piezoelectric layer 42 and extends over the BO structure 56. An outer peripheral edge of the BO structure 56 may be aligned with a peripheral edge of the top electrode 58. The entire top electrode structure 44 has a width W_{TE}.

The BAW resonator 36 is divided into an active region 60 and an outside region 62. The active region 60 corresponds to a section of the BAW resonator 36 where the top and bottom electrodes 58, 48 overlap and also includes the layers in-between and below the overlapping top and bottom electrodes 58, 48. The outside region 62 corresponds to the section of the BAW resonator 36 that surrounds the active region 60. The active region 60 is divided into a central region 64 and a BO region 66. The BO region 66 corresponds to a section of the BAW resonator 36 that includes, resides over, and resides below the BO structure 56. The central region 64 is defined laterally inside the BO region 66 and is not covered by the BO structure 56. The BO region 66 has a width W_{R}, which is between 2 µm and 4 µm depending on different applications, while the central region 64 has a width W_{CEN}.

Notably, the bottom electrode 48 may extend beyond the peripheral edge of the top electrode 58. As previously described, the active region 60 is formed where the top and bottom electrodes 58, 48 overlap. In this manner, misalignment of the top electrode 58 with the bottom electrode 48 during fabrication may impair performance of the BAW resonator 36. By arranging the bottom electrode 48 with larger lateral dimensions than the top electrode 58, alignment tolerances for placement of the top electrode 58 may be increased, thereby improving manufacturing tolerances.

The BO structure 56 at least includes a BO ring 68 formed about an outer periphery of the BO region 66 and a ring transition section 70 formed about an inner periphery of the BO region 66. The BO ring 68 has a fixed ring height H_{R} ranging between 40 nm to 120 nm, while the ring transition section 70 has a variable height varying from zero to the ring height H_{R} to form a tapered wall. An angle α formed between the tapered wall of the ring transition section 70 and a horizontal plane (e.g., parallel with a top surface of the piezoelectric layer 42) is between 30 and 60 degrees.

In one embodiment, the top electrode 58 includes a first top electrode layer 72 formed over the piezoelectric layer 42 within the central region 64 and extending over the BO structure 56, an electrode seed layer 74 formed over the first top electrode layer 72, and a second top electrode layer 76 formed over the electrode seed layer 74. Herein, the first top electrode layer 72 may be formed of W, Mo, Pt, or other electrically conductive materials with high acoustic impedance properties. The electrode seed layer 74 may be formed of Titanium Tungsten (TiW) or Titanium (Ti). The second top electrode layer 76 may be formed of AlCu or other highly electrically conductive materials.

In addition, the BO structure 56 may be formed of an oxide material, such as SiO₂. In one embodiment, the top electrode 58 has a uniform thickness, and mass loading portions of the top electrode structure 44 come from the BO structure 56. In another embodiment, the BO structure 56 may be formed of a same material as the first top electrode layer 72, such as W, Mo, Pt, or other electrically conductive materials.

The reflector 38 includes a low acoustic impedance region 78, and multiple high acoustic impedance layers 80 are embedded within the low acoustic impedance region 78. For the purpose of this illustration, there are two high acoustic impedance layers 80: a first high acoustic impedance layer 80-1, which is the nearest high acoustic impedance layer to the transducer 46 within the reflector 38, and a second high acoustic impedance layer 80-2 underneath the first high acoustic impedance layer 80-1. In different applications, there may be more high acoustic impedance layers 80 embedded in the low acoustic impedance region 78 and underneath the second high acoustic impedance layer 80-2.

Herein, the first high acoustic impedance layer 80-1 is vertically underneath the second bottom electrode layer 54 of the bottom electrode 48 and is separate from the second bottom electrode layer 54 of the bottom electrode 48 by a first portion 78-1 (i.e., a top portion) of the low acoustic impedance region 78. The second high acoustic impedance layer 80-2 is vertically underneath the first high acoustic impedance layer 80-1 and is separated from the first high acoustic impedance layer 80-1 by a second portion 78-2 of the low acoustic impedance region 78. A third portion 78-3 of the low acoustic impedance region 78 is underneath the second high acoustic impedance layer 80-2. The low acoustic impedance region 78 has lower acoustic impedance, lower density, and lower stiffness than the high acoustic impedance layers 80 and may be formed of a low acoustic impedance material, such as SiO₂. Each high acoustic impedance layer 80 is formed of a high acoustic impedance material, such as W, Mo, or Pt. The first portion 78-1 of the low acoustic impedance region 78, the first high acoustic impedance layer 80-1, the second portion 78-2 of the low acoustic impedance region 78, the second high acoustic impedance layer 80-2, and the third portion 78-3 of the low acoustic impedance region 78 are RLs of the reflector 38.

Notice that, in order to enable the BO modes to leak into a substrate at a periphery of the active region 60 (e.g., in the BO region 66), thereby suppressing the BO modes of the BAW resonator 36, a width W_{FH} of the first high acoustic impedance layer 80-1 must be smaller than the width W_{TE} of the top electrode structure 44. On the other hand, to maintain a relatively high quality factor, the first high acoustic impedance layer 80-1 is desired to extend completely through the central region 64 and the width W_{FH} of the first high acoustic impedance layer 80-1 is no smaller than the width W_{CEN} of the central region 64.

As illustrated in FIG. 7A, the second high acoustic impedance layer 80-2 extends completely through the active region 60 (i.e., the BO structure 56 is confined within the second high acoustic impedance layer 80-2, a width W_{SH} of the second high acoustic impedance layer 80-2 is greater than the width W_{TE} of the top electrode structure 44) and may have a peripheral edge aligned with the peripheral edge of the bottom electrode 48. In some applications, the second high acoustic impedance layer 80-2 may extend laterally beyond the peripheral edge of the bottom electrode 48 (not shown). In one embodiment, the first high acoustic impedance layer 80-1 does not extend into the BO region 66 (i.e., the BO structure 56 and the first high acoustic impedance layer 80-1 has no overlap), and a peripheral edge of the first high acoustic impedance layer 80-1 is aligned with a peripheral edge of the central region 64. Herein, the peripheral edge alignment between the first high acoustic impedance layer 80-1 and the central region 64 has an alignment tolerance (e.g., less than 200 nm) due to process variations. A first width difference W_{D1} between the peripheral edge of the first high acoustic impedance layer 80-1 and the outer peripheral edge of the BO structure 56 is the same as the width W_{R} of the BO region 66. As such, within the BO region 66/vertically underneath the BO structure 56, a portion of the low acoustic impedance region 78 fills vertically between a top surface of the second high acoustic impedance layer 80-2 and the bottom electrode 48. In one embodiment, the first high acoustic impedance layer 80-1 extends into the BO region 66 but does not extend completely through the BO region 66, where the peripheral edge of the first high acoustic impedance layer 80-1 is confined in the BO region 66 (not shown). As such, the first width difference W_{D1} between the peripheral edge of the first high acoustic impedance layer 80-1 and the outer peripheral edge of the BO structure 56 is larger than zero and smaller than the width W_{R} of the BO region 66.

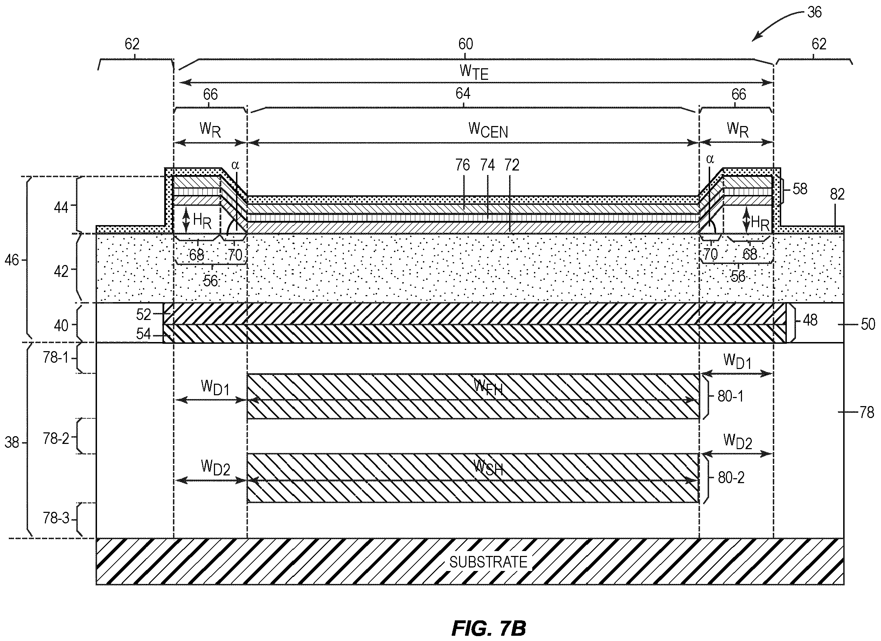

To further suppress the BO modes of the BAW resonator 36 (i.e., having an enhanced BO mode leaking performance), the width W_{SH} of the second high acoustic impedance layer 80-2 may also be smaller than the width W_{TE} of the top electrode structure 44, as illustrated in FIG. 7B. Similar to the first high acoustic impedance layer 80-1, the second high acoustic impedance layer 80-2 is also desired to extend completely through the central region 64 and the width W_{SH} of the second high acoustic impedance layer 80-2 is not smaller than the width W_{CEN} of the central region 64.

In one embodiment, the second high acoustic impedance layer 80-2 does not extend into the BO region 66 (i.e., the BO structure 56 and the second high acoustic impedance layer 80-2 have no overlap). Both the peripheral edge of the first high acoustic impedance layer 80-1 and a peripheral edge of the second high acoustic impedance layer 80-2 are aligned with the peripheral edge of the central region 64. Herein, the peripheral edge alignment among the first high acoustic impedance layer 80-1, the second high acoustic impedance layer 80-2, and the central region 64 has an alignment tolerance (e.g., less than 200 nm) due to process variations. The first width difference W_{D1} between the peripheral edge of the first high acoustic impedance layer 80-1 and the outer peripheral edge of the BO structure 56 and a second width difference W_{D2} between the peripheral edge of the second high acoustic impedance layer 80-2 and the outer peripheral edge of the BO structure 56, each is the same as the width W_{R} of the BO region 66. As such, in the reflector 38, there is no high acoustic impedance layer (e.g., no high acoustic impedance layer 80-1 or 80-2) existing within the BO region 66/under the BO structure 56. A portion of the low acoustic impedance region 78 is formed within the BO region 66/under the BO structure 56.

In one embodiment, at least one of the first high acoustic impedance layer 80-1 and the second high acoustic impedance layer 80-2 extends into the BO region 66 but does not extend completely through the BO region 66. As such, the peripheral edge of the first or second high acoustic impedance layer 80-1 or 80-2 is confined in the BO region 66, while the peripheral edge of the other high acoustic impedance layer is either aligned with the peripheral edge of the central region 64 or confined in the BO region 66 (not shown). The first width difference W_{D1} between the peripheral edge of the first high acoustic impedance layer 80-1 and the outer peripheral edge of the BO structure 56 and the second width difference W_{D2} between the peripheral edge of the second high acoustic impedance layer 80-2 and the outer peripheral edge of the BO structure 56 may be different or the same.

Furthermore, the BAW resonator 36 may also include a passivation layer 82 to protect the example BAW resonator 36 from an external environment. The passivation layer 82 covers the top electrode structure 44 and portions of the piezoelectric layer 42 exposed through the top electrode structure 44. The passivation layer 82 may be formed of Silicon Nitride (SiN), SiO₂, or Silicon Oxynitride (SiON), with a thickness between 250 Å and 5000 Å.

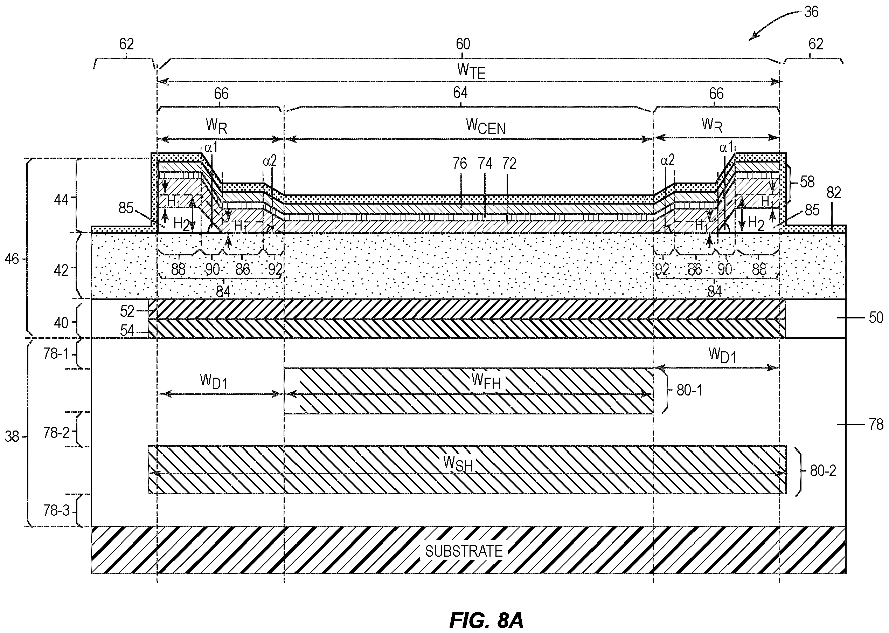

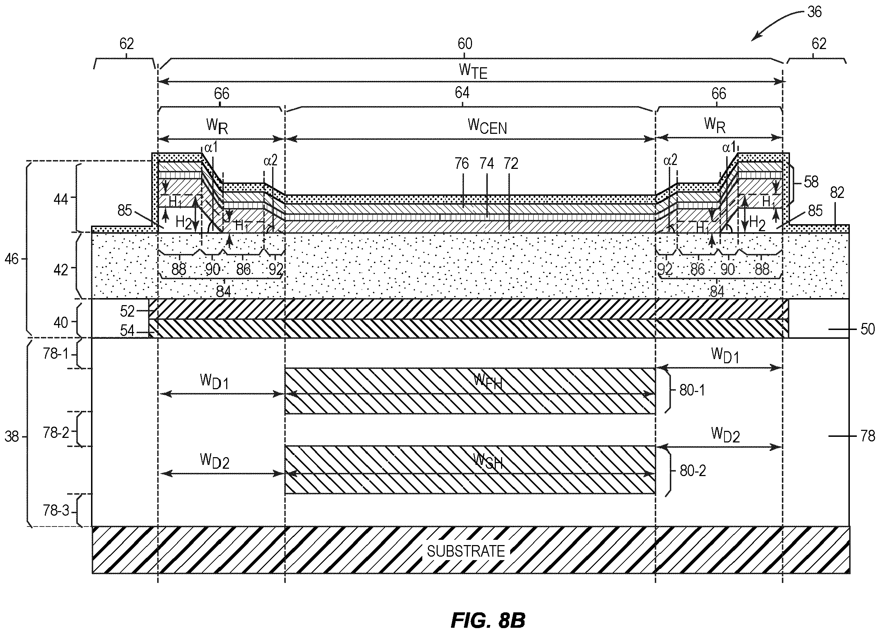

The BAW resonator 36, as illustrated in FIGs. 7A and 7B, includes the top electrode structure 44 with the single-step configuration BO structure 56. In different applications, the top electrode structure 44 has a dual-step configuration BO structure 84 instead of the single-step configuration BO structure 56, as illustrated in FIGs. 8A and 8B. The dual-step BO structure 84 is formed over the piezoelectric layer 42 and about the periphery of the top electrode structure 44, such that the central portion of the piezoelectric layer 42 is not covered by the dual-step BO structure 84. The top electrode 58 is formed over the central portion of the piezoelectric layer 42 and extends over the dual-step BO structure 84. An outer peripheral edge of the dual-step BO structure 84 may be aligned with the peripheral edge of the top electrode 58. In addition, the passivation layer 82 still covers the top electrode structure 44 and portions of the piezoelectric layer 42 exposed through the top electrode structure 44.

Herein, the BAW resonator 36 is still divided into the active region 60 (corresponding to the section of the BAW resonator 36 where the top and bottom electrodes 58, 48 overlap and also includes the layers in-between and below the overlapping top and bottom electrodes 58, 48) and the outside region 62 (corresponding to the section of the BAW resonator 36 that surrounds the active region 60). The active region 60 is divided into the central region 64 and the BO region 66. The BO region 66 corresponds to a section of the BAW resonator 36 that includes, resides over, and resides below the dual-step BO structure 84. The central region 64 is defined laterally inside of the BO region 66 and is not covered by the dual-step BO structure 84. The BO region 66 has the width W_{R}, which is between 1 µm and 4 µm depending on different applications, while the central region 64 has the width W_{CEN}.

The dual-step BO structure 84 includes an inner step 86 with a first height H1 and an outer step 88 with a second height H2. The inner step 86 and the outer step 88 collectively form a stepped profile of raised heights that decrease from the outer periphery of the dual-step BO structure 84 toward the central region 64. The inner step 86 is a first mass loading portion of the top electrode structure 44 and the outer step 88 is a second mass loading portion of the top electrode structure 44. In one embodiment, the inner step 86 is formed due to a thickness increment (H1) of the first top electrode layer 72 within the BO region 66, while the outer step 88 is formed due to the thickness increment (H1) of the first top electrode layer 72 within the BO region 66 and a dielectric BO ring 85 (with a thickness H2-H1) about the outer periphery of the dual-step BO structure 84. The dielectric BO ring 85 is located vertically between the top electrode 58 and the piezoelectric layer 42, and an outer peripheral edge of the dielectric BO ring 85 is aligned with the peripheral edge of the top electrode 58. The dielectric BO ring 85 may be formed of SiO₂. By having a dual-step configuration, the mass loading portions of the top electrode structure 44 within the BO region 66 is thereby configured to provide two different acoustic impedances. This provides acoustic impedance mismatch for laterally propagating Lamb waves within the BAW resonator 36 that would otherwise contribute to a loss of energy or energy leakage and the reduction of the Q factor for the BAW resonator 36.

To achieve the height variation between the inner step 86 and the outer step 88, the dual-step BO structure 84 further includes a first transition section 90 laterally between the inner step 86 and the outer step 88. A height of the first transition section 90 varies from the first height H1 to the second height H2 to form a tapered wall. A first angle α1 formed between the tapered wall of the first transition section 90 and a horizontal plane (e.g., parallel with a top surface of the piezoelectric layer 42) is between 30 and 60 degrees. In addition, the dual-step BO structure 84 also includes a second transition section 92 formed about an inner periphery of the BO region 66, and laterally between the central region 64 and the inner step 86. A height of the second transition section 92 varies from zero to the first height H1 to form a tapered wall. A second angle α2 formed between the tapered wall of the second transition section 92 and the horizontal plane (e.g., parallel with the top surface of the piezoelectric layer 42) is between 30 and 60 degrees. The first angle α1 and the second angle α2 may be different or the same.

In order to effectively suppress the BO modes of the BAW resonator 36 and maintain a relatively high quality factor, within the reflector 38, the width W_{FH} of the first high acoustic impedance layer 80-1 must be smaller than the width W_{TE} of the top electrode structure 44 and no smaller than the width W_{CEN} of the central region 64. The first high acoustic impedance layer 80-1 is desired to extend completely through the central region 64.

As illustrated in FIG. 8A, the second high acoustic impedance layer 80-2 extends completely through the active region 60 (i.e., the dual-step BO structure 84 confined within the second high acoustic impedance layer 80-2, the width W_{SH} of the second high acoustic impedance layer 80-2 is greater than the width W_{TE} of the top electrode structure 44) and may have a peripheral edge aligned with the peripheral edge of the bottom electrode 48. In some applications, the second high acoustic impedance layer 80-2 may extend laterally beyond the peripheral edge of the bottom electrode 48 (not shown). In one embodiment, the first high acoustic impedance layer 80-1 does not extend into the BO region 66 (i.e., the dual-step BO structure 84 and the first high acoustic impedance layer 80-1 has no overlap), and a peripheral edge of the first high acoustic impedance layer 80-1 is aligned with a peripheral edge of the central region 64. Herein, the peripheral edge alignment between the first high acoustic impedance layer 80-1 and the central region 64 has an alignment tolerance (e.g., less than 200 nm) due to process variations. A first width difference W_{D1} between the peripheral edge of the first high acoustic impedance layer 80-1 and the outer peripheral edge of the dual-step BO structure 84 is the same as the width W_{R} of the BO region 66. As such, within the BO region 66/vertically underneath the dual-step BO structure 84, a portion of the low acoustic impedance region 78 fills vertically between a top surface of the second high acoustic impedance layer 80-2 and the bottom electrode 48. In one embodiment, the first high acoustic impedance layer 80-1 extends into the BO region 66 but does not extend completely through the BO region 66, where the peripheral edge of the first high acoustic impedance layer 80-1 is confined in the BO region 66 (not shown). As such, the first width difference W_{D1} between the peripheral edge of the first high acoustic impedance layer 80-1 and the outer peripheral edge of the dual-step BO structure 84 is larger than zero and smaller than the width W_{R} of the BO region 66.

To further suppress the BO modes of the BAW resonator 36, the width W_{SH} of the second high acoustic impedance layer 80-2 may also be smaller than the width W_{TE} of the top electrode structure 44, as illustrated in FIG. 8B. Similar to the first high acoustic impedance layer 80-1, the second high acoustic impedance layer 80-2 is also desired to extend completely through the central region 64 and the width W_{SH} of the second high acoustic impedance layer 80-2 is not smaller than the width W_{CEN} of the central region 64.

In one embodiment, the second high acoustic impedance layer 80-2 does not extend into the BO region 66 (i.e., the dual-step BO structure 84 and the second high acoustic impedance layer 80-2 has no overlap). Both the peripheral edge of the first high acoustic impedance layer 80-1 and a peripheral edge of the second high acoustic impedance layer 80-2 are aligned with the peripheral edge of the central region 64. Herein, the peripheral edge alignment among the first high acoustic impedance layer 80-1, the second high acoustic impedance layer 80-2, and the central region 64 has an alignment tolerance (e.g., less than 200 nm) due to process variations. The first width difference W_{D1} between the peripheral edge of the first high acoustic impedance layer 80-1 and the outer peripheral edge of the dual-step BO structure 84 and a second width difference W_{D2} between the peripheral edge of the second high acoustic impedance layer 80-2 and the outer peripheral edge of the dual-step BO structure 84, each is the same as the width W_{R} of the BO region 66. As such, in the reflector 38, there is no high acoustic impedance layer (e.g., no high acoustic impedance layer 80-1 or 80-2) existing within the BO region 66/under the dual-step BO structure 84. A portion of the low acoustic impedance region 78 is formed within the BO region 66/vertically underneath the dual-step BO structure 84.

In one embodiment, at least one of the first high acoustic impedance layer 80-1 and the second high acoustic impedance layer 80-2 extends into the BO region 66 but does not extend completely through the BO region 66. As such, the peripheral edge of the first or second high acoustic impedance layer 80-1 or 80-2 is confined in the BO region 66, while the peripheral edge of the other high acoustic impedance layer is either aligned with the peripheral edge of the central region 64 or confined in the BO region 66 (not shown). The first width difference W_{D1} between the peripheral edge of the first high acoustic impedance layer 80-1 and the outer peripheral edge of the dual-step BO structure 84 and the second width difference W_{D2} between the peripheral edge of the second high acoustic impedance layer 80-2 and the outer peripheral edge of the dual-step BO structure 84 may be different or the same.

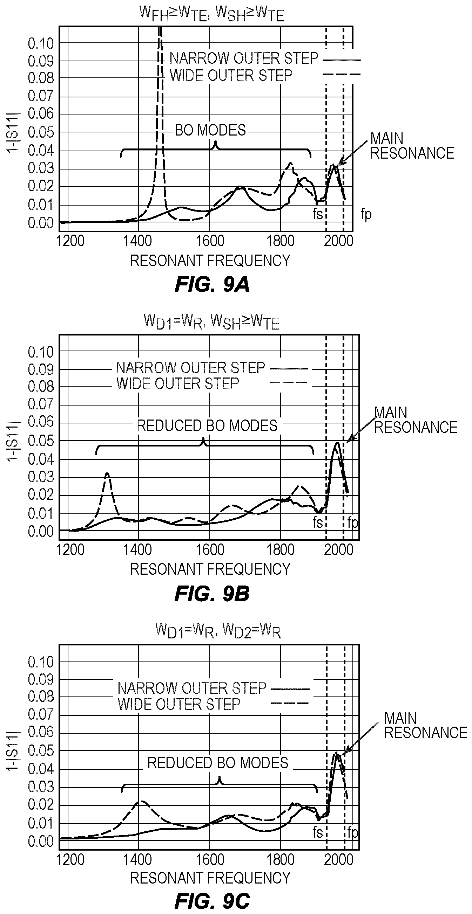

FIGs. 9A -9C illustrate simulation results of 1-|S₁₁| responses for various BAW resonators with a dual-step BO structure (e.g., the dual-step BO structure 84). Herein, 1-|S₁₁| is equal to the power ratio lost in a resonator. FIG. 9A shows 1-|S₁₁| responses of two simulated BAW resonators, where one of these two simulated BAW resonators has a narrow outer step in the dual-step BO structure, while the other BAW resonator has a wide outer step in the dual-step structure. In these two simulated BAW resonators, each high acoustic impedance layer (e.g., each of the first high acoustic impedance layer 80-1 and the second high acoustic impedance layer 80-2) extends completely through a corresponding active region (e.g., the active region 60). A width of each high acoustic impedance layer width (e.g., each of W_{FH} and W_{SH}) is not smaller than a width of a corresponding top electrode structure (e.g., W_{TE} of the top electrode structure 44).

FIG. 9B shows 1-|S₁₁| responses of two simulated BAW resonators, which have a same configuration as shown in FIG. 8A. One of these two simulated BAW resonators has a narrow outer step in the dual-step BO structure, while the other BAW resonator has a wide outer step in the dual-step structure. In these two simulated BAW resonators, a nearest high acoustic impedance layer (e.g., the first high acoustic impedance layer 80-1) does not extend into a corresponding BO region (e.g., the BO region 66), and has a peripheral edge aligned with a peripheral edge of a corresponding central region (e.g., the peripheral edge of the central region 64). A width difference between the peripheral edge of the nearest high acoustic impedance layer and an outer peripheral edge of the dual-step BO structure (e.g., the first width difference W_{D1}) is the same as a width of the corresponding BO region (e.g., the width W_{R} of the BO region 66). In addition, a high acoustic impedance layer(s) other than the nearest high acoustic impedance layer (e.g., the second high acoustic impedance layer 80-2) extends completely through the corresponding active region (e.g., the active region 60) and has a width (e.g., W_{SH}) no smaller than the width of the corresponding top electrode structure (e.g., W_{TE} of the top electrode structure 44).

FIG. 9C shows 1-|S₁₁| responses of two simulated BAW resonators, which have a same configuration as shown in FIG. 8B. One of these two simulated BAW resonators has a narrow outer step in the dual-step BO structure, while the other BAW resonator has a wide outer step in the dual-step structure. In these two simulated BAW resonators, each high acoustic impedance layer (e.g., each of the first high acoustic impedance layer 80-1 and the second high acoustic impedance layer 80-2) does not extend into a corresponding BO region (e.g., the BO region 66), and has a peripheral edge aligned with a peripheral edge of a corresponding central region (e.g., the peripheral edge of the central region 64). A width difference between the peripheral edge of each high acoustic impedance layer and an outer peripheral edge of the dual-step BO structure (e.g., the first width difference W_{D1} or the second width difference W_{D2}) is the same as the width of the corresponding BO region (e.g., the width W_{R} of the BO region 66).

It is clearly shown that when the nearest high acoustic impedance layer (e.g., the first high acoustic impedance layer 80-1) does not extend into the corresponding BO region (e.g., the BO region 66), and has the peripheral edge aligned with the peripheral edge of the corresponding central region (e.g., the central region 64), the BO modes are significantly suppressed, especially for the BAW resonators with the wide outer step in the dual-step BO structure (FIGs. 9B and 9C). When the rest of the high acoustic impedance layers (e.g., the second high acoustic impedance layer 80-2) also do not extend into the corresponding BO region (e.g., the BO region 66), and have the peripheral edge aligned with the peripheral edge of the corresponding central region (e.g., the central region 64), the BO modes are further suppressed, especially for the BAW resonators with the wide outer step in the dual-step BO structure (FIG. 9C).

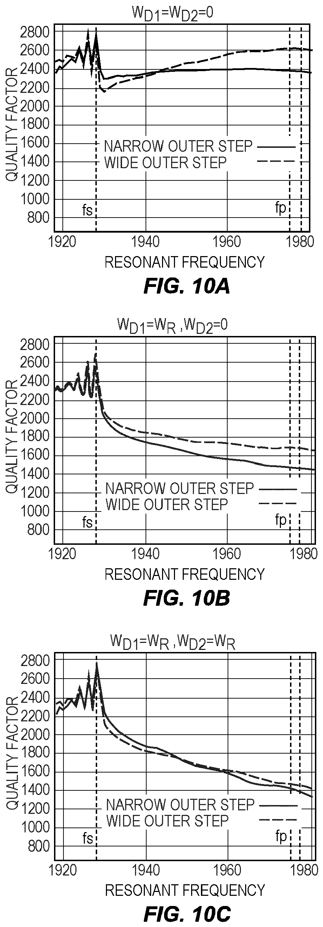

FIGs. 10A -10C illustrate quality factor simulation results for various BAW resonators. FIG. 10A shows quality factor simulation results of the two simulated BAW resonators utilized in FIG. 9A, FIG. 10B shows quality factor simulation results of the two simulated BAW resonators utilized in FIG. 9B, and FIG. 10C shows quality factor simulation results of the two simulated BAW resonators utilized in FIG. 9C.

Because of the shortage of one or more high acoustic impedance layers within the BO region 66, the lateral energy confinement is degraded, which results in a decreased value of a quality factor (FIGs. 10B and 10C) compared to one BAW resonator with the BO structure fully confined within each high acoustic impedance layer (FIG. 10A). On the other hand, the proposed BAW resonators with one BO structure and utilizing the shortage of one or more high acoustic impedance layers within the BO region yet provide quality factor values higher than BAW resonators with no BO structure. Therefore, for some applications, which require a balance between the quality factor values and the BO mode suppressions, the proposed BAW resonators with one BO structure and utilizing the shortage of one or more high acoustic impedance layers within the BO region are particularly desirable.

Therefore, from one perspective, there has been described a bulk acoustic wave (BAW) resonator that includes a bottom electrode, a top electrode structure with a border ring (BO) structure, a piezoelectric layer sandwiched between the bottom electrode and the top electrode, and a reflector with a high acoustic impedance layer embedded in a low acoustic impedance region. The BO structure is formed about a periphery of the top electrode structure and defines a BO region of the BAW resonator. The high acoustic impedance layer is vertically underneath the bottom electrode and is separated from the bottom electrode by a first portion of the low acoustic impedance region. A width of the first high acoustic impedance layer is smaller than a width of the top electrode structure, such that the first high acoustic impedance layer does not extend completely through the BO region of the BAW resonator.

Further examples are set out in the following numbered clauses.

Clause 1. A bulk acoustic wave (BAW) resonator comprising: a bottom electrode; a piezoelectric layer over the bottom electrode; a top electrode structure including a border ring (BO) structure over the piezoelectric layer, wherein: the BO structure is formed about a periphery of the top electrode structure and defines a BO region of the BAW resonator; and the BO region corresponds to a section of the BAW resonator that includes, resides over, and resides below the BO structure; and a reflector including a first high acoustic impedance layer and a second high acoustic impedance layer embedded in a low acoustic impedance region, wherein: the first high acoustic impedance layer is vertically underneath the bottom electrode and is separate from the bottom electrode by a first portion of the low acoustic impedance region; the second high acoustic impedance layer is vertically underneath the first high acoustic impedance layer and is separate from the first high acoustic impedance layer by a second portion of the low acoustic impedance region; and a width of the first high acoustic impedance layer is smaller than a width of the top electrode structure, such that the first high acoustic impedance layer does not extend completely through the BO region of the BAW resonator.

Clause 2. The BAW resonator of clause 1, wherein the BO structure has a single-step configuration.

Clause 3. The BAW resonator of clause 2, wherein the BO structure includes a dielectric BO ring formed about an outer periphery of the BO region and a ring transition section formed about an inner periphery of the BO region.

Clause 4. The BAW resonator of clause 1, wherein the BO structure has a dual-step configuration.

Clause 5. The BAW resonator of any preceding clause, wherein: the top electrode structure further includes a top electrode, which is formed over a central portion of the piezoelectric layer and extends over the BO structure; and an outer peripheral edge of the BO structure is aligned with a peripheral edge of the top electrode.

Clause 6. The BAW resonator of clause 5, wherein: the top electrode includes a first top electrode layer, which is formed over the central region of the piezoelectric layer and extends over the BO structure, an electrode seed layer formed over the first top electrode layer, and a second top electrode layer formed over the electrode seed layer.

Clause 7. The BAW resonator of clause 6, wherein: the first top electrode layer is formed of tungsten (W), molybdenum (Mo), or platinum (Pt); the electrode seed layer is formed of Titanium Tungsten (TiW) or Titanium (Ti); and the second top electrode layer is formed of aluminum copper.

Clause 8. The BAW resonator of clause 5, 6 or 7, wherein: the BO structure has a dual-step configuration with an inner step and an outer step, wherein the inner step and the outer step collectively form a stepped profile of raised heights that decrease from the outer periphery of the BO structure toward the central region of the piezoelectric layer; the inner step is formed due to a thickness increment of the first top electrode layer within the BO region; and the outer step is formed due to the thickness increment of the first top electrode layer within the BO region and a dielectric BO ring about an outer periphery of the BO region.

Clause 9. The BAW resonator of any preceding clause, wherein the first high acoustic impedance layer does not extend into the BO region of the BAW resonator, and a width difference between a peripheral edge of the first high acoustic impedance layer and an outer peripheral edge of the BO structure is the same as a width of the BO region of the BAW resonator.

Clause 10. The BAW resonator of any preceding clause, wherein a width of the second high acoustic impedance layer is smaller than the width of the top electrode structure, such that the second high acoustic impedance layer does not extend completely through the BO region of the BAW resonator.

Clause 11. The BAW resonator of clause 10, wherein: the first high acoustic impedance layer does not extend into the BO region of the BAW resonator, and a width difference between a peripheral edge of the first high acoustic impedance layer and an outer peripheral edge of the BO structure is the same as a width of the BO region of the BAW resonator; and the second high acoustic impedance layer does not extend into the BO region of the BAW resonator, and a peripheral edge of the second high acoustic impedance layer is aligned with the peripheral edge of the first high acoustic impedance layer.

Clause 12. The BAW resonator of clause 11, wherein the BO structure has a single-step configuration.

Clause 13. The BAW resonator of clause 11, wherein the BO structure has a dual-step configuration.

Clause 14. The BAW resonator of any preceding clause, wherein a width of the second high acoustic impedance layer is greater than the width of the first high acoustic impedance layer, and the first high acoustic impedance layer is confined within a peripheral edge of the second high acoustic impedance layer.

Clause 15. The BAW resonator of clause 14, wherein the width of the second high acoustic impedance layer is not smaller than the width of the top electrode structure.

Clause 16. The BAW resonator of clause 15, wherein the width of the second high acoustic impedance layer is greater than the width of the top electrode structure, such that the second high acoustic impedance layer extends completely through the BO region of the BAW resonator.

Clause 17. The BAW resonator of clause 16, wherein the first high acoustic impedance layer does not extend into the BO region of the BAW resonator, and a width difference between a peripheral edge of the first high acoustic impedance layer and an outer peripheral edge of the BO structure is the same as a width of the BO region of the BAW resonator.

Clause 18. The BAW resonator of clause 17, wherein the BO structure has a single-step configuration.

Clause 19. The BAW resonator of clause 17, wherein the BO structure has a dual-step configuration.

Clause 20. The BAW resonator of any preceding clause, wherein: the first high acoustic impedance layer and the second high acoustic impedance layer are formed of W, Mo, or Pt; and the low acoustic impedance region is formed of silicon oxide.

Clause 21. The BAW resonator of any preceding clause further comprising a passivation layer that covers the top electrode structure and portions of the piezoelectric layer exposed through the top electrode structure, wherein the passivation layer is formed of Silicon Nitride (SiN), SiO2, or Silicon Oxynitride (SiON), with a thickness between 250 Å and 5000 Å.

It is contemplated that any of the foregoing aspects, and/or various separate aspects and features as described herein, may be combined for additional advantage. Any of the various embodiments as disclosed herein may be combined with one or more other disclosed embodiments unless indicated to the contrary herein.

Those skilled in the art will recognize improvements and modifications to the illustrative embodiments of the present disclosure. All such improvements and modifications are considered within the scope of the concepts disclosed herein and the claims that follow.

## Claims

1. A bulk acoustic wave (BAW) resonator comprising:
a bottom electrode;
a piezoelectric layer over the bottom electrode;
a top electrode structure including a border ring (BO) structure over the piezoelectric layer, wherein:
the BO structure is formed about a periphery of the top electrode structure and defines a BO region of the BAW resonator; and
the BO region corresponds to a section of the BAW resonator that includes, resides over, and resides below the BO structure; and
a reflector including a first high acoustic impedance layer and a second high acoustic impedance layer embedded in a low acoustic impedance region, wherein:
the first high acoustic impedance layer is vertically underneath the bottom electrode and is separate from the bottom electrode by a first portion of the low acoustic impedance region;
the second high acoustic impedance layer is vertically underneath the first high acoustic impedance layer and is separate from the first high acoustic impedance layer by a second portion of the low acoustic impedance region; and
a width of the first high acoustic impedance layer is smaller than a width of the top electrode structure, such that the first high acoustic impedance layer does not extend completely through the BO region of the BAW resonator.

2. The BAW resonator of claim 1, wherein the BO structure has a single-step configuration.

3. The BAW resonator of claim 2, wherein the BO structure includes a dielectric BO ring formed about an outer periphery of the BO region and a ring transition section formed about an inner periphery of the BO region.

4. The BAW resonator of claim 1, wherein the BO structure has a dual-step configuration.

5. The BAW resonator of any preceding claim, wherein:
the top electrode structure further includes a top electrode, which is formed over a central portion of the piezoelectric layer and extends over the BO structure; and
an outer peripheral edge of the BO structure is aligned with a peripheral edge of the top electrode.

6. The BAW resonator of claim 5, wherein:
the top electrode includes a first top electrode layer, which is formed over the central region of the piezoelectric layer and extends over the BO structure, an electrode seed layer formed over the first top electrode layer, and a second top electrode layer formed over the electrode seed layer.

7. The BAW resonator of claim 5 or 6, wherein:
the first top electrode layer is formed of tungsten (W), molybdenum (Mo), or platinum (Pt);
the electrode seed layer is formed of Titanium Tungsten (TiW) or Titanium (Ti); and
the second top electrode layer is formed of aluminum copper.

8. The BAW resonator of claim 5, 6 or 7, wherein:
the BO structure has a dual-step configuration with an inner step and an outer step, wherein the inner step and the outer step collectively form a stepped profile of raised heights that decrease from the outer periphery of the BO structure toward the central region of the piezoelectric layer;
the inner step is formed due to a thickness increment of the first top electrode layer within the BO region; and
the outer step is formed due to the thickness increment of the first top electrode layer within the BO region and a dielectric BO ring about an outer periphery of the BO region.

9. The BAW resonator of any preceding claim, wherein the first high acoustic impedance layer does not extend into the BO region of the BAW resonator, and a width difference between a peripheral edge of the first high acoustic impedance layer and an outer peripheral edge of the BO structure is the same as a width of the BO region of the BAW resonator.

10. The BAW resonator of any preceding claim, wherein a width of the second high acoustic impedance layer is smaller than the width of the top electrode structure, such that the second high acoustic impedance layer does not extend completely through the BO region of the BAW resonator, and for example wherein:
the first high acoustic impedance layer does not extend into the BO region of the BAW resonator, and a width difference between a peripheral edge of the first high acoustic impedance layer and an outer peripheral edge of the BO structure is the same as a width of the BO region of the BAW resonator; and
the second high acoustic impedance layer does not extend into the BO region of the BAW resonator, and a peripheral edge of the second high acoustic impedance layer is aligned with the peripheral edge of the first high acoustic impedance layer.

11. The BAW resonator of any preceding claim, wherein a width of the second high acoustic impedance layer is greater than the width of the first high acoustic impedance layer, and the first high acoustic impedance layer is confined within a peripheral edge of the second high acoustic impedance layer.

12. The BAW resonator of claim 11, wherein the width of the second high acoustic impedance layer is not smaller than the width of the top electrode structure.

13. The BAW resonator of claim 12, wherein the width of the second high acoustic impedance layer is greater than the width of the top electrode structure, such that the second high acoustic impedance layer extends completely through the BO region of the BAW resonator, and for example wherein the first high acoustic impedance layer does not extend into the BO region of the BAW resonator, and a width difference between a peripheral edge of the first high acoustic impedance layer and an outer peripheral edge of the BO structure is the same as a width of the BO region of the BAW resonator.

14. The BAW resonator of any preceding claim, wherein:
the first high acoustic impedance layer and the second high acoustic impedance layer are formed of W, Mo, or Pt; and
the low acoustic impedance region is formed of silicon oxide.

15. The BAW resonator of any preceding claim further comprising a passivation layer that covers the top electrode structure and portions of the piezoelectric layer exposed through the top electrode structure, wherein the passivation layer is formed of Silicon Nitride (SiN), SiO2, or Silicon Oxynitride (SiON), with a thickness between 250 Å and 5000 Å.
